# EUROPEAN PATENT SPECIFICATION

(11) **EP 1 455 961 B1**
(45) Date of publication and mention of the grant of the patent: **10.12.2008**
(21) Application number: 02788857.7
(22) Date of filing: 19.12.2002
(51) Int. Cl.: B21C 25/02

(54) **EXTRUSION TOOL AND METHOD FOR MANUFACTURING SHAPED ARTICLE WITH FINS**
EXTRUSIONSWERKZEUG UND VERFAHREN ZUR HERSTELLUNG VON FORMKÖRPER MIT RIPPEN UND KÜHLKÖRPER
OUTIL D'EXTRUSION ET PROCEDE POUR FABRIQUER DES ARTICLES EXTRUDES COMPORTANT DES AILETTES

(30) Priority: 19.12.2001 JP 2001386176; 31.01.2002 US 352597 P
(43) Date of publication of application: 15.09.2004
(73) Proprietor: Showa Denko K.K., Tokyo 105-8513 (JP)
(72) Inventor: FUJIOKA, Makoto, Oyama Reg. Off., SHOWA DENKO K.K., Oyama-shi, Tochigi 323-0811 (JP)
(74) Representative: Viering, Hans-Martin
(86) International application number: PCT/JP2002/013299
(87) International publication number: WO 2003/051552

(56) References cited:
- JP-A- 1 254 315
- JP-A- 6 114 436
- JP-A- 62 279 019
- JP-U- 61 064 100

## Description

Priority is claimed to Japanese Patent Application No. 2001-386176, filed on December 19, 2001 and U.S. Provisional Patent Application No. 60/352,597, filed on January 31, 2002, the disclosure of which are incorporated by reference in their entireties.

### Technical Field

The present invention relates to an extrusion tool according to the preamble of claim 1 and to a method for manufacturing a shaped article with fins by using the extrusion tool.

### Background Art

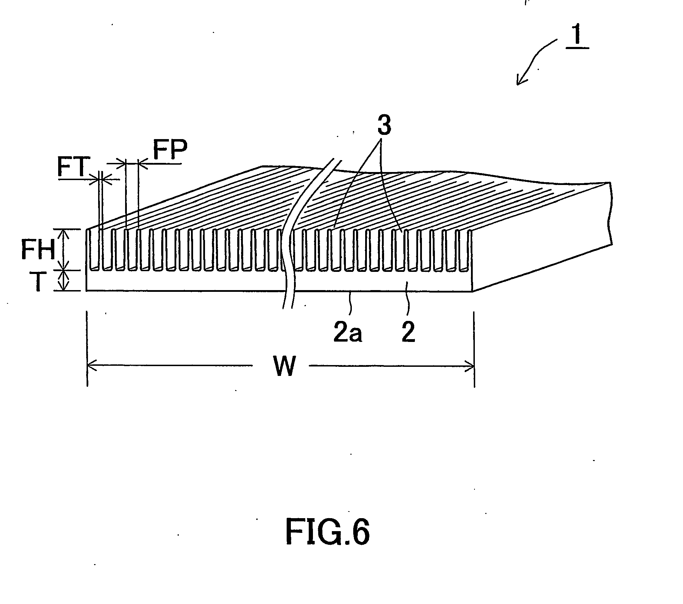

An extrusion tool of the initially-mentioned type is known frame, JP-A-01 254 315. As one of heat releasing members used in electronic devices or the like, as shown in Fig. 6, an aluminum heat sink 1 having a number of thin plate-type fins 3 arranged like comb-teeth on one side of a substrate 2 can be exemplified. This heat sink 1 is used in such a manner that a heat generation element is attached to the other side 2a of the substrate 2.

In the heat sink 1, the fins 3 are required to be large in tong ratio in order to enhance the heat releasing performance, and the other side of the substrate 2 is required to be flat so that a heat generation element can be attached in a closely fitted manner so as not to inhibit heat conduction from the heat generation element.

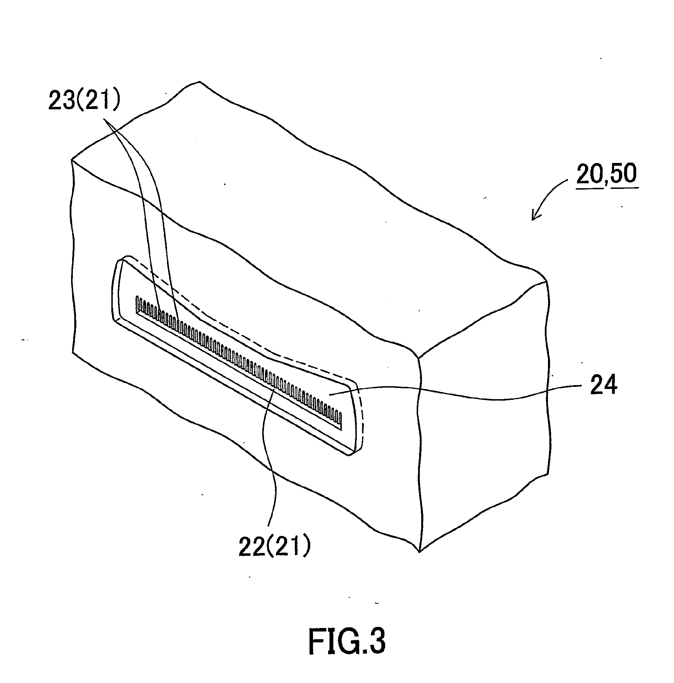

In many cases, as shown in Fig. 3, such a heat sink 1 is produced by an extrusion method using a die 50 having a bearing hole 21 corresponding to the circumferential configuration of the heat sink 1 because of the merit capable of manufacturing with fewer processes. The bearing hole 21 consists of a substrate forming portion 22 corresponding to the substrate 2 and fin forming portions 23 corresponding to the fins 3.

Furthermore, in general, when extruding a complex shaped article, uneven flow resistance of extruding material occurs depending on the bearing width of the die 50 and the distance from the bearing surface, which causes such a problem that the extruded article may have defects such as distortion, bending depending on the difference of material flow amount. One of the counter measures for such defects is to adjust the entire material flow amount balance by enlarging the bearing length at a portion with weaker flow resistance to thereby increase the flow resistance.

The aforementioned problem also occurs when extruding the heat sink 1, and therefore the flow balance is adjusted by changing the bearing length to obtain high tong ratio and high degree of flatness of the substrate 2. In details, in order to obtain fins 3 with high tong ratio, the bearing length of the substrate forming portion 22 which causes smaller flow resistance is so adjusted to be set longer than that of the fin forming portions 23. In addition, in order to obtain flatness of the substrate 2, the flow balance is adjusted by increasing the bearing length of the widthwise middle portion of the substrate forming portion 22 which causes smaller flow resistance than that of both end portions.

However, in setting up the bearing length to obtain flatness of the substrate 2, many trials must be repeated to individually cope with the matters since not only the size of the substrate 2 but also another factors such as the entire shape including the fins 3, extruding conditions and types of materials affect each other in a complex manner. Thus, the setting is time consuming and troublesome operations. Moreover, since a wider width W of the substrate 2 causes larger flow resistance difference between the end portions and the widthwise middle portion, deformation tends to occur and the degree of deformation is large. Therefore, the operations for setting the bearing length becomes complex.

Furthermore, in many cases, satisfactory degree of flatness is hard to be obtained in regard of a close contact with a heat generation element even when the bearing length of the substrate forming portion 22 is adjusted after troublesome operations. Therefore, the flatness is obtained by further conducting post-processing. In the post-processing, the extruded shaped article is subjected to roll straightening to obtain a roughly straightened article, and thereafter the fitting surface 2a thereof to be attached to a heat generation element is ground. However, the higher the fins 3 get, the more difficult the operation of roll straightening becomes. Therefore, the aforementioned method is not a counter measure for achieving perfect flatness of the substrate 2. In other words, the aforementioned method is not a counter measure for assuredly manufacturing a heat sink having excellent heat releasing performance.

### Disclosure of the Invention

In view of the aforementioned technical background, the present invention aims to provide an extrusion tool capable of extruding a shaped article with fins such as a heat sink having a substrate with excellent flatness, and a method for manufacturing a shaped article with fins using the extrusion tool

To this end, the present invention provides an extrusion tool according to claim 1 and a method according to claim 2. Further embodiments of the extrusion tool and the method of the present invention are described in the respective dependent claims.

For information, in this specification, the wording of "front" or "front end" denotes the outlet side of extruding material or the traveling direction of extruding material, whereas the wording of "rear" or "rear end" denotes the inlet side of extruding material or the direction opposite to the traveling direction of extruding material.

According to the first aspect of the present invention, there is provided an extrusion tool 10 for extruding a shaped article 1 with fins having a substrate 2 and a plurality of thin plate-type fins 3 arranged like comb-teeth on one side of the substrate 2, wherein the extrusion tool 10 comprises:
a die main body 20 having a bearing hole 21 for defining an external configuration of the shaped article 1, the bearing hole 21 including a substrate forming portion 22 corresponding to the substrate 2 and fin forming portions 23 corresponding to the fins 3; and
a plate member 30 to be disposed at an upstream side of the die main body 20,
wherein the plate member 30 is provided with a material passage 31 penetrating in the fore-and-aft direction and communicates with an upstream side opening of the bearing hole 21 of the die main body 20, and
wherein the plate member 30 is provided with at least one vertical partitioning wall 33, 34 so as to cross the substrate forming portion 22 of the bearing hole 21 in the thickness direction of the substrate 2 in a state in which the plate member 30 is combined with the die main body 20, whereby the material passage 31 is divided into a plurality of small passages 31a, 31b, 31c, 31d, 31e and 31f.

It is preferable that two or more vertical partitioning walls 33, 34 are provided in the material passage 31 of the plate member 30.

It is preferable that a merging space 37a, 37 b communicating with the plurality of small passages 31a, 31b, 31c, 31d, 31e, 31f is provided at a downstream side of the material passage 31 of the plate member 30.

It is preferable that the vertical partitioning wall 33 , 34 is formed so as to cross the fin forming portions 23.

It is preferable that the extrusion tool further comprises a horizontal partitioning wall 32 formed in the material passage 31 of the plate member 30, wherein the horizontal partitioning wall 32 is positioned at a boundary portion between the substrate forming portion 22 and the fin forming portions 23 in a state in which the plate member 30 is combined with the die main body 20.

It is preferable that the horizontal partitioning wall 32 is formed to have an inclined surface 35 at a front portion facing the substrate forming portion 22, the inclined surface 35 being inclined toward the fin forming portions 23.

It is preferable that the die main body 20 is provided with a dented portion 24 formed at an upstream side thereof and communicated with the bearing hole 21 for introducing the extruding material into the bearing hole 21.

According to the second aspect of the present invention, there is provided a method for manufacturing a shaped article with a plurality of thin plate-type fins 3 arranged like comb-teeth on one side of a substrate 2, said method comprising:
preparing an extrusion tool 10 according to the above first aspect; and
extruding an extruding material using the extrusion tool 10 such that the extruding material divided by the small passages 31a, 31b, 31c, 31d, 31e, 31f of the plate member 30 is merged to be pressed and adhered and then extruded through the bearing hole 21.

It is preferable that the extruding material is aluminum.

It is preferable that the shaped article with a plurality of thin plate-type fins is a heat sink.

With the extrusion tool according to the present invention, since the flow resistance is uniformalized in the widthwise direction of the substrate forming portion of the bearing hole, the accurate bearing hole size can be obtained. Therefore, a substrate with high degree of flatness can be obtained.

In cases where two or more vertical partitioning walls are provided in the extrusion tool, the flow resistance can be further uniformalized, thereby causing a substrate with excellent degree of flatness.

Furthermore, in cases where a merging space communicating with the small passages is provided at the downstream side of the material passage of the plate member, the merging of extruding material can be conducted in the plate member.

Furthermore, in cases where the vertical partitioning wall is provided so as to cross the fin forming portions, flow resistance difference can be decreased.

In cases where the horizontal partitioning wall is formed in the material passage of the plate member so as to position at a boundary portion between the substrate forming portion and the fin forming portions in a state in which the plate member is combined with the die main body, the flow rate in the fin forming portions can be adjusted and therefore fins with high tong ratio can be preferably formed.

It is preferable that the horizontal partitioning wall is formed to have an inclined surface inclined toward the fin forming portions. This can increase the flow amount toward the substrate forming portion.

It is preferable that the dented portion communicated with the bearing hole for introducing the extruding material to the bearing hole is formed at the upstream portion of the die main body. In this case, the merging of extruding material can be performed in the die main body.

According to the method for manufacturing a shaped article with fins of the present invention, the extruding material divided into and supplied through the small passages in the plate member are merged to be pressed and adhered, and then extruded through the bearing hole. Therefore, the flow resistance in the widthwise direction of the substrate forming portion of the bearing hole can be uniformalized. Accordingly, an accurate size of the bearing hole can be obtained, resulting in a substrate with high degree of flatness, which in turn enables to obtain a predetermined degree of flatness without post-processing.

The method for manufacturing the shaped article with fins can be preferably applied when aluminum is used as extruding material.

In addition, it is preferable that the shaped article with fins is a heat sink. A heat sink which has excellent heat releasing performance and can closely fit to a heat generation element can be produced due to the excellent degree of flatness of the substrate. Furthermore, since post-processing for obtaining flatness is not required, an excellent heat sink can be manufactured with easy process.

Since the heat sink is produced as mentioned above, the heat sink can closely fit to a heat generation element, resulting in excellent heat releasing performance.

### Brief description of drawing

Fig. 1 is a rear view showing an embodiment of an extrusion tool according to the present invention viewed from the rear end of a plate member constituting the extrusion tool.
Fig. 2 is a cross-sectional view taken along the line II-II of Fig. 1 showing the extrusion process of a heat sink using the extrusion tool shown in Fig. 1.
Fig. 3 is a perspective view showing a die main body viewed from the rear upper side thereof.
Fig. 4 is a perspective view showing the plate member viewed from the front upper side thereof.
Fig. 5 is a cross-sectional view taken along the line V-V of Fig. 1 showing the extrusion process of the heat sink using the extrusion tool shown in Fig. 1.
Fig.6 is a perspective view showing the heat sink to be manufactured by the extrusion tool shown in Fig. 1.

### Best Mode for Carrying Out the Invention

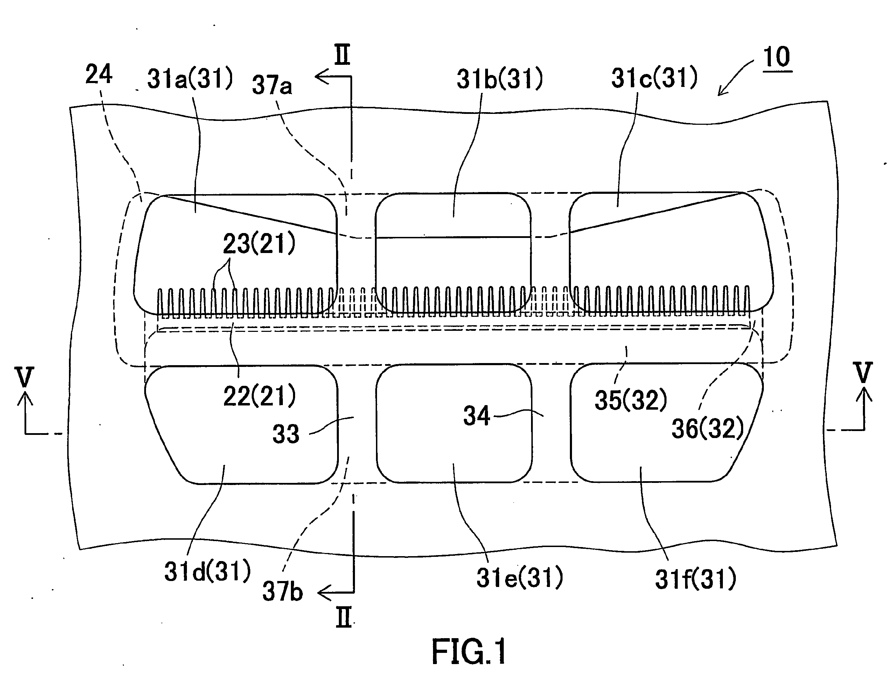

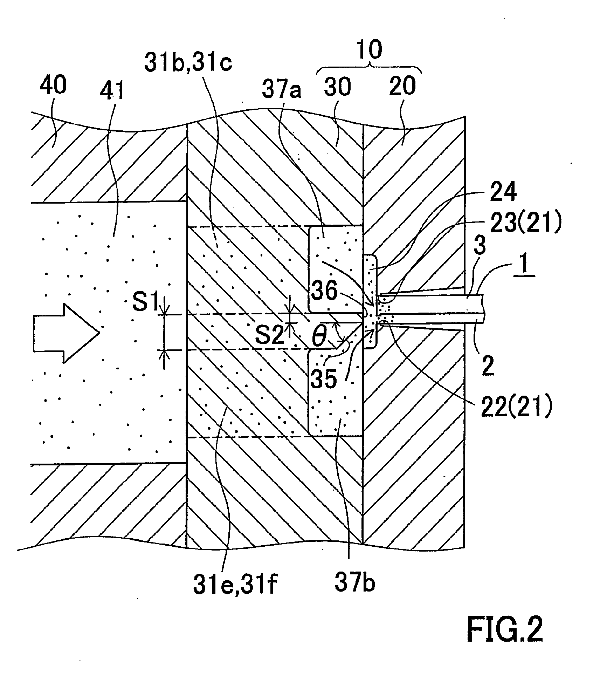

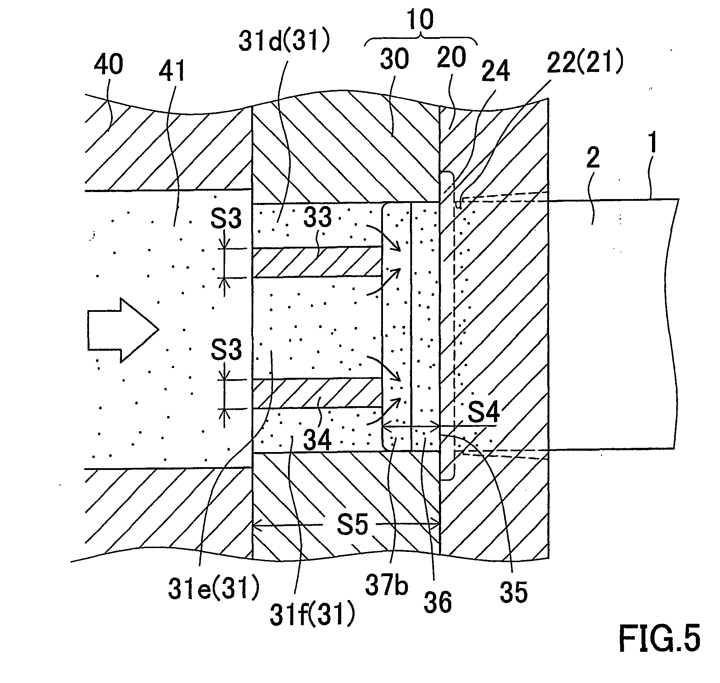

Figs. 1 to 5 show one embodiment of an extrusion tool 10 according to the present invention which is used to extrude an aluminum heat sink 1 in which a number of thin plate-type fins 3 are arranged like comb-teeth on one side of a thick substrate 2 as shown in Fig. 6. In Figs. 2 and 5, the reference numeral "40" denotes a container and "41" denotes extruding material loaded in this container 40.

The extrusion tool 10 includes a die main body 20 and a plate member 30 combined with the die main body 20

As shown in Figs. 1-3 and 5, the die main body 20 has a bearing hole 21 for defining the external periphery of the heat sink 1. The bearing hole 21 consists of a substrate forming portion 22 corresponding to the substrate 2 and fin forming portions 23 corresponding to the fins 3. Formed behind the bearing hole 21 is a dented portion 24 for introducing extruding material to the bearing hole 21.

As shown in Figs. 1, 2, 4 and 5, the plate member 30 has a material passage 31 which penetrates in the fore-and-aft direction and guides the extruding material to the rear end opening of the dented portion 24 of the die main body 20. The material passage 31 is divided into six individual small passages 31a, 31b, 31c, 31d, 31e and 31f by a horizontal partitioning wall 32 disposed at the vertically bisected position and two vertical partitioning walls 33 and 34 disposed at the horizontally trisected positions.

In a state in which the plate member 30 is combined with the die main body 20, as shown in Figs. 1 and 2, the horizontal partitioning wall 32 is positioned approximately at the boundary portion between the substrate forming portion 22 and the fin forming portions 23 of the die main body 20 with the inclined surface 35 formed at the tip end portion thereof inclined toward the fin forming portions 23, while its tip surface 36 thereof is positioned in the same plane as the front end surface of the plate member 30. The horizontal partitioning wall 32 divides the extruding material 41 into the upper small passages 31a, 31b and 31c and the lower small passage 31d, 31e and 31f before introducing the extruding material into the die main body 20. When the extruding material is introduced into the die main body 20, the inclined surface 35 of the horizontal partitioning wall 32 increases the flow amount of the extruding material toward the plate forming portion 22 because of the enlarged cross-sectional area of the lower passages 31d, 31e and 31f.

In the state in which the plate member 30 is combined with the die main body 20, the aforementioned vertical partitioning walls 33 and 34 are disposed perpendicular to the substrate forming portion 22 and the fin forming portions 23 at the positions where the bearing hole 21 is trisected in the widthwise W direction of the substrate 2. These vertical partitioning walls 33 and 34 are located behind the front end surface of the plate member 30. At the front end side of the material passage 31, the upper three small passages 31a, 31b and 31c are communicated with each other to thereby form an upper merging space 37a. Similarly, the lower three small passages 31d, 31e and 31f are communicated with each other to thereby form a lower merging space 37b. The vertical partitioning walls 33 and 34 divide the extruding material 41 into the left upper and lower small passages 31a and 31d, the central upper and lower small passages 31b and 31e and the right upper and lower small passages 31c and 31f. The extruding material 41 passing through these upper (lower) small passages 31a, 31b and 31c (31d, 31e and 31f) and divided into three flows in the horizontal direction merges in the merging space 37a (37b) to be pressed and integrally adhered (see Fig. 5)

Therefore, in the extrusion tool 10 in a state in which the die main body 20 and the plate member 30 are combined, extruding material flows and the heat sink 1 is formed as follows.

The extruding material 41 in the container 40 is divided into and passes through six individual small passages 31a, 31b, 31c, 31d, 31e and 31f of the plate member 30, and the extruding material 41 passes through the upper small passages 31a, 31b and 31c and then merges to be pressed and integrally adhered with each other in the upper merging space 37a, while the extruding material 41 passed through the lower small passages 31d, 31e and 31f merges to be pressed and integrally adhered in the lower merging space 37b. That is, the extruding material 41 divided into six in the horizontal and vertical directions at the downstream side end portion of the plate member 30 are joined at the upper and lower merging spaces, respectively, to cause two flows, i.e., the upper flow and the lower flow. Thereafter, these two flows are merged to be pressed and integrally adhered in the dented portion 24 of the die main body 20. Thus, the extruding material 41 is integrally extruded through the bearing hole 21, forming the heat sink 1 of the predetermined configuration.

When the extruding material passes through the passage 31 of the plate member 30, a relatively large flow resistance occurs at portions near lateral ends of the passage 31 and near the vertical partitioning walls 33 and 34. On the other hand, a relatively small flow resistance occurs at portions away them. Thus, the flow resistance differs along the transversal direction of the passage. This difference in flow resistance gradually decreases as the extruding material passing through the laterally arranged three small passages 31a, 31b and 31c merges in the merging space 37a(37b) and then the extruding material passing through the upper merging space 37a and the lower merging space 37b merges in the dented portion 24 of the die main body 20: Then, the merged extruding material is introduced into the bearing hole 21 in a state in which the flow balance is substantially uniformalized. As a result, the flow resistance in the widthwise direction of the substrate forming portion 22 in the bearing hole 21 is uniformalized, and extrusion can be conducted with size of a bearing hole accurately reflected, and therefore the substrate 2 having high degree of flatness can be formed.

In the plate member 30 according to this embodiment of the present invention, in addition to the aforementioned vertical partitioning walls 33, 34, the horizontal partitioning wall 32 is formed. This horizontal partitioning wall 32 contributes to the forming of fins with high tong ratio since it causes an increased flow resistance in the fin forming portions 23 by dividing the extruding material 41 into the upper and lower flows. In addition to the substrate 2 with flatness formed by the aforementioned vertical partitioning walls 33 and 34, by the horizontal partitioning wall 32, fins 3 with high tong ratio can be formed. This makes it possible to extrude a heat sink with excellent heat releasing performance.

An extrusion tool according to the present invention, however, is not limited to the aforementioned embodiment.

At least one vertical partitioning wall of the plate member 30 can decrease the difference in flow resistance in the widthwise direction of the substrate forming portion 22. It is preferable that two or more vertical partitioning walls 33 and 34 of the plate member 30 are provided. The appropriate number of vertical partitioning walls 33 and 34 varies depending on the width W of the substrate 2. The wider the width W is, the more the number of vertical partitioning walls 33 and 34 becomes. However, too many vertical partitioning walls 33 and 34 may cause inconvenience such as too large flow resistance as a whole and/or deterioration of strength of partitioning walls due to the narrowed width thereof. For example, the number of vertical partitioning wall is preferably two or three when the width W of the substrate 2 is about 300 mm.

Furthermore, in the aforementioned embodiment, although the vertical partitioning walls 33 and 34 are provided so as to cross the substrate forming portion 22 of the bearing hole 21 and the fin forming portions 23, these walls may be provided so as to cross at least the substrate forming portion 22. However, it is preferable that these walls are disposed so as to cross the substrate forming portion 22 and the fin forming portions 23 so as to decrease the flow resistance difference.

Furthermore, in the aforementioned extrusion tool 10, although the merging of extruding material 41 divided in the horizontal direction is conducted in the upper and lower merging spaces of the plate member 30 and the merging of extruding materials 41 divided in the vertical direction is conducted in the dented portion 24 of the die main body 20, the positions for merging the extruding material are not limited to the above. For example, the merging of extruding material in the vertical direction may be conducted in the plate member 30, and a die main body having a bearing hole formed at the rear surface thereof may be combined with the plate member. Alternatively, an additional plate member having an extruding material merging space may be disposed between the die main body 20 and the plate member 30.

Furthermore, in the extrusion tool according to the present invention, the shape of the substrate forming portion 22 of the die main body 20, or the shape of the substrate of an extruded article with fins, is not limited to the aforementioned flat-plate shape. For example, in the present invention, the substrate forming portion, or the substrate of the extruded article, may have legs or the like for attaching it to a heat generation element.

According to the method for producing a shaped article with fins, the extrusion tool 10 is used, and extruding material supplied in a divided manner through small passages 31a, 31b, 31c, 31d, 31e and 31f of the plate member 30 are merged and then extruded through the bearing hole 21. Therefore, the flow resistance in the widthwise direction of the substrate forming portion 22 can be uniformalized, which enables the manufacturing of a shaped article having fins with excellent degree of flatness of the substrate 2. Accordingly, a predetermined shaped article with fins can be manufactured without conducting post-processing such as roll straightening and/or grinding.

Such a shaped article with fins can be preferably manufactured when the extruding material is aluminum. The kind of aluminum is not limited to a specific one and can be widely selected among high purity aluminum, JIS A1000 series aluminum or its alloy, Al-Cu based alloy of JIS A2000 series, Al-Mn based alloy of JIS A3000 series, Al-Si based alloy of JIS A4000 series, Al-Mg based alloy of JIS A5000 series, Al-Si-Mg based alloy of JIS A6000 series, Al-Zn-Mg-Cu or Al-Zn-Mg based alloy of JIS A7000 series and the like.

Furthermore, the aforementioned manufacturing method is suitably used for producing a heat sink and is capable of obtaining a substrate with excellent degree of flatness. Therefore, a heat sink with a good contact with various types of heat generation elements can be produced by extrusion only. As heat sink material, JIS A 6000 aluminum alloy with good extrusion and heat conduction, particularly JIS A6063 aluminum alloy, can be recommended.

### Examples

Experiments on extrusion were conducted using an extrusion tool 1 shown in Figs. 1 to 5 and several types of extrusion tools in which the number of vertical partitioning walls in the plate member 30 was changed.

In the heat sink 1, a width W of the substrate 2 was set to be 299.8 mm, the thickness T of the substrate 2 was set to be 6.5 mm, the thickness FT of the fin 3 was set to be 1.5 mm, the height FH of the fin 3 was set to be 15.5 mm, and the fin pitch FP was set to be 4.2 mm.

In the extrusion tool 10, the die main body 20 was formed to have a bearing hole 21 having a size corresponding to the size of the substrate forming portion 22 and the fin forming portions 23 of the aforementioned heat sink 1. The depth of the dented portion 24 was set to be 10 mm.

Plate members 30 having a common horizontal partitioning wall 32 and four different number of vertical partitioning walls as shown below were prepared and combined with the die main body 20. In the horizontal partitioning wall 32, the thickness S1 was set to be 26 mm, the width S2 of the tip end surface 36 was set to be 4 mm, and the inclination angle θ of the inclined surface 35 was set to be 45° (see Fig. 2) . Furthermore, in the vertical partitioning walls, regardless of its number, the thickness S3 was set to be 20 mm and the depth S4 of the merging space 37a (37b) was set to be 40 mm while the thickness S5 of the plate member 30 was set to be 130 mm (see Fig. 5).

### (Example 1)

One vertical partitioning wall was formed at the widthwise central position of the material passage 31, i.e., at the center of the substrate forming portion 22, in a state in which the plate member is combined with the die main body 10. Therefore, the material passage 31 was divided into four by one vertical partitioning wall and one horizontal partitioning wall.

### (Example 2)

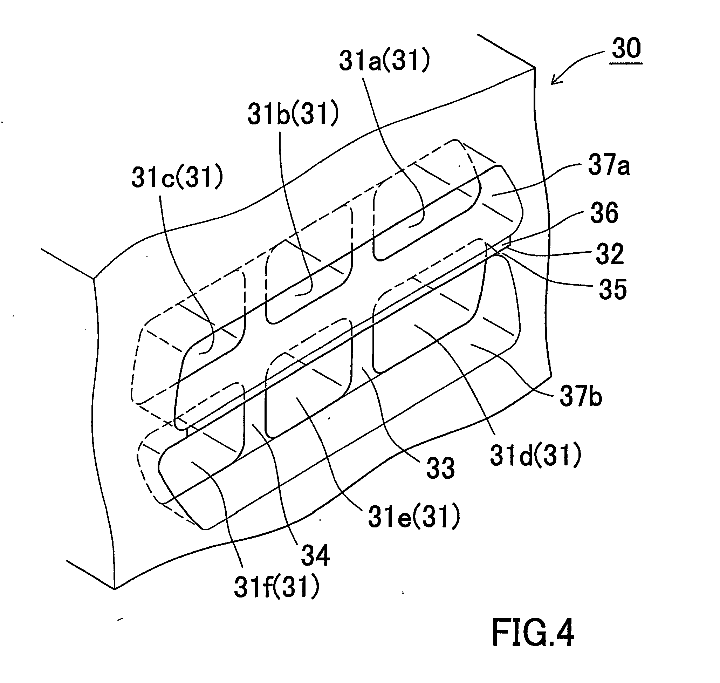

Two vertical partitioning walls were formed at the positions where the material passage 31 was trisected in the horizontal direction, i.e., at the positions shown in Fig. 4. Therefore, the material passage 31 was divided into six by two vertical partitioning walls and one horizontal partitioning wall.

### (Example 3)

Three vertical partitioning walls were formed at the positions where the material passage 31 was quadrisected in the horizontal direction. Therefore, the material passage 31 was divided into eight by three vertical partitioning walls and one horizontal partitioning wall.

### (Comparative Example)

No vertical partition was formed. Therefore, the material passage 31 was divided into two by only one horizontal partitioning wall.

Using the aforementioned four types of extrusion tools, ten elongated shaped articles with length of 3100 mm were extruded by using JIS A6063 aluminum alloy as extruding material, respectively.

In each of obtained ten elongated shaped articles, the degree of flatness of the substrate was measured. The degree of flatness is represented by the difference between the highest position and the lowest position in the fitting surface 2a to the heat generation element or the like. The minimum value (which means the most excellent degree of flatness) to the maximum value in each degree of flatness of ten elongated shaped articles is shown in Table 1.

**Table 1**

| | Example 1 | Example 2 | Example 3 | Comparative Example |
|---|---|---|---|---|
| Number of vertical partitioning wall | 1 | 2 | 3 | None |
| Degree of flatness(mm) | 1.2-1.5 | 0.5-1.0 | 0.3-0.8 | 2.0-3.0 |

From the results shown in Table 1, it was confirmed that the degree of flatness of the substrate can be improved by providing at least one vertical partitioning wall in the material passage of the plate member.

Furthermore, in the heat sinks manufactured by using the extrusion tools of Examples 1 to 3, the degree of flatness of the substrate were in a satisfactory level in regard of close contact with the heat generation element. In addition, there was no deformation in fins and they were extruded in a satisfactory manner.

While illustrative embodiments of the present invention have been described herein, the present invention is not limited to the various preferred embodiments described herein, but includes any and all embodiments having modifications, omissions, combinations (e.g., of aspects across various embodiments), adaptations and/or alterations as would be appreciated by those in the art based on the present disclosure. The limitations in the claims are to be interpreted broadly based the language employed in the claims and not limited to examples described in the present specification or during the prosecution of the application, which examples are to be construed as non-exclusive. For example, in the present disclosure, the term "preferably" is non-exclusive and means "preferably, but not limited to." Means-plus-function or step-plus-function limitations will only be employed where for a specific claim limitation all of the following conditions are present in that limitation: a) "means for" or "step for" is expressly recited; b) a corresponding function is expressly recited; and c) structure, material or acts that support that structure are not recited.

### Industrial applicability

According to the extrusion tool of the present invention, since the material flow resistance in the widthwise direction of the substrate forming portion of the bearing hole can be uniformalized, the substrate with excellent degree of flatness can be formed. Furthermore, since the flow resistance in the fin forming portions increases as compared to that in the substrate forming portion, fins with high tong ratio can be formed. Thus, it is suitably, used for manufacturing a heat sink in which a substrate can closely contact with a heat generation element, and a heat sink with excellent heat releasing performance can be obtained.

## Claims

1. An extrusion tool (10) for extruding a shaped article (1) with fins having a substrate (2) and a plurality of thin plate-type fins (3) arranged like comb-teeth on one side of the substrate (2), said extrusion tool (10) comprising:
a die main body (20) having a bearing hole (21) for defining an external configuration of the shaped article (1), said bearing hole (21) including a substrate forming portion (22) corresponding to the substrate (2) and fin forming portions (23) corresponding to the fins (3) ; and
a plate member (30) to be disposed at a downstream side of said die main body (20),
wherein said plate member (30) is provided with a material passage (31) penetrating in the fore and aft direction and communicates with an upstream side opening of said bearing hole (21) of said die main body (20), **characterized in that**
said plate member (30) is provided with at least one vertical partitioning wall (33) (34) so as to cross said substrate forming portion (22) of said bearing hole (21) in the thickness direction of the substrate (2) in a state in which said plate member (30) is combined with said die main body (20), whereby the material passage (31) is divided into a plurality of small passages (31a) (31b) (31c) (31d) (31e) (31f).

2. The extrusion tool as recited in claim 1, wherein two or more vertical partitioning walls (33)(34) are provided in said material passage (31) of said plate member (30).

3. The extrusion tool as recited in claim 1 or 2, wherein a merging space (37 a) (37 b) communicating said plurality of small passages (31a) (31b) (31c), (31d) (31e) (31f) is provided at a downstream side portion of said material passage (31) of said plate member (30).

4. The extrusion tool as recited an any one of claims 1 to 3, wherein said vertical partitioning wall (33) (34) is formed so as to cross said fin forming portions (23).

5. The extrusion tool as recited in any one of claims to 4, further comprising a horizontal .partitioning wall (32) formed in said material passage (31) of said plate member (30), wherein said horizontal partitioning wall (32) is positioned at a boundary portion between said substrate forming portion (22) and said fin forming portions (23) in a state in which said plate member (30) is combined with said die main body (20).

6. The extrusion tool as recited in claim 5, wherein said horizontal partitioning wall (32) is formed to have an inclined surface (35) at a front portion facing said substrate forming portion, (22), said inclined surface (35) being inclined toward said fin forming portions (23).

7. The extrusion tool as recited in any one of claims 1 to 6, wherein said die main body (20) is provided with a dented portion (24) formed at an upstream side portion thereof and communicated with said bearing hole (21) for introducing the extruding material into said bearing hole (21).

8. a method for manufacturing a shaped article with a plurality of thin plate-type fins (3) arranged like comb-teeth on one side of a substrate (2), said method comprising:
preparing an extrusion tool (10) according to any of claims 1-7; and
extruding an extruding material using said extrusion tool (10) such that the extruding material divided by said small passages (31a) (31b) (31c) (31d) (31e) (31f) of said plate member (30) is merged to be pressed and adhered and then extruded through said bearing hole (21).

9. The method for manufacturing a shaped article with fins as recited in claim 8, wherein the extruding material is aluminum.

10. The method for manufacturing a shaped article with fins as recited in claim 8 or 9, wherein the shaped article with a plurality of thin plate-type fins is a heat sink.

## Patentansprüche

1. Extrusionswerkzeug (10) zum Extrudieren eines geformten Artikels (1) mit Finnen, der ein Substrat (2) und eine Mehrzahl von dünnen plattenartigen Finnen (3) aufweist, die wie Kammzähne an einer Seite des Substrats (2) angeordnet sind, wobei das Extrusionswerkzeug (10) aufweist:
einen Matrizen-Hauptkörper (20), der eine Lageröffnung (21) zum Definieren einer äußeren Konfiguration des geformten Artikels (1) aufweist, wobei die Lageröffnung (21) einen dem Substrat (2) entsprechenden Substrat-Formungs-Abschnitt (22) und den Finnen (3) entsprechende Finnen-Formungs-Abschnitte (23) aufweist, und
ein Plattenelement (30) zum Anordnen an einer Stromabwärts-Seite des Matrizen-Hauptkörpers (20),
wobei das Plattenelement (30) mit einem in der Längsrichtung durchdringenden Materialdurchgang (31) versehen ist und mit einer Stromaufwärts-Seitenöffnung der Lageröffnung (21) des Matrizen-Hauptkörpers (20) kommuniziert, **dadurch gekennzeichnet, dass**
das Plattenelement (30) mit mindestens einer vertikalen Trennwand (33) (34) versehen ist, um sich in einem Zustand, in dem das Plattenelement (30) mit dem Matrizen-Hauptkörper (20) kombiniert ist, quer durch den Substrat-Formungs-Abschnitt (22) der Lageröffnung (21) in Richtung der Dicke des Substrats (2) zu erstrecken, wodurch der Materialdurchgang (31) in eine Mehrzahl von kleinen Durchgängen (31a) (31b) (31c) (31d) (31e) (31f) geteilt wird.

2. Extrusionswerkzeug gemäß Anspruch 1, wobei zwei oder mehrere vertikale Trennwände (33) (34) in dem Materialdurchgang (31) des Plattenelements (30) vorgesehen sind.

3. Extrusionswerkzeug gemäß Anspruch 1 oder 2, wobei ein Fusionier-Abschnitt (37 a) (37 b), der mit der Mehrzahl von kleinen Durchgängen (31a) (31b) (31c) (31d) (31e) (31f) kommuniziert, an einem Stromabwärtsseiten-Abschnitt des Materialdurchgangs (31) des Plattenelements (30) vorgesehen ist.

4. Extrusionswerkzeug gemäß einem der Ansprüche 1 bis 3, wobei die vertikale Trennwand (33) (34) so ausgebildet ist, dass sie die Finnen-Formungs-Abschnitte (23) durchquert.

5. Extrusionswerkzeug gemäß einem der Ansprüche 1 bis 4, das ferner eine horizontale Trennwand (32) aufweist, die in dem Materialdurchgang (31) des Plattenelements (30) ausgebildet ist, wobei die horizontale Trennwand (32) an einem Abgrenzungsabschnitt zwischen dem Substrat-Formungs-Abschnitt (22) und den Finnen-Formungs-Abschnitten (23) in einem Zustand, in dem das Plattenelement (30) mit dem Matrizen-Hauptkörper (23) kombiniert ist, positioniert ist.

6. Extrusionswerkzeug gemäß Anspruch 5, wobei die horizontale Trennwand (32) so ausgebildet ist, dass sie eine geneigte Fläche (35) an einem vorderen Abschnitt, der dem Substrat-Formungs-Abschnitt (22) zugewandt ist, aufweist, wobei die geneigte Fläche (35) in Richtung zu den Finnen-Formungs-Abschnitten (23) geneigt ist.

7. Extrusionswerkzeug gemäß einem der Ansprüche 1 bis 6, wobei der Matrizen-Hauptkörper (20) mit einem Vertiefungsabschnitt (24) versehen ist, der an einem Stromaufwärtsseiten-Abschnitt davon ausgebildet ist und mit der Lageröffnung (21) kommuniziert, um das Extrusionsmaterial in die Lageröffnung (21) einzuführen.

8. Verfahren zum Herstellen eines geformten Artikels mit einer Mehrzahl von dünnen plattenartigen Finnen (3), die wie Kammzähne an einer Seite eines Substrats (2) angeordnet sind, wobei das Verfahren aufweist:
Vorbereiten eines Extrusionswerkzeugs (10) gemäß einem der Ansprüche 1 bis 7, und
Extrudieren eines Extrusionsmaterials unter Verwendung des Extrusionswerkzeugs (10), so dass das Extrusionsmaterial, das durch die kleinen Durchgänge (31a) (31b) (31c) (31d) (31e) (31f) des Plattenelements (30) geteilt wird, so fusioniert wird, dass es gepresst und geklebt und dann durch die Lageröffnung (21) extrudiert wird.

9. Verfahren zum Herstellen eines geformten Artikels mit Finnen gemäß Anspruch 8, wobei das Extrusionsmaterial Aluminium ist.

10. Verfahren zum Herstellen eines geformten Artikels mit Finnen gemäß Anspruch 8 oder 9, wobei der geformte Artikel mit einer Mehrzahl von dünnen plattenartigen Finnen ein Kühlkörper ist.

## Revendications

1. Outil d'extrusion (10) pour extruder un article profilé (1) avec des ailettes ayant un substrat (2) et une pluralité de fines ailettes de type plaque (3) agencées en dents de peigne sur un côté du substrat (2), ledit outil d'extrusion (10) comprenant :
un corps principal de filière (20) ayant un orifice de dégagement (21) pour définir une configuration externe de l'article profilé (1), ledit orifice de dégagement (21) comprenant une partie de formation de substrat (22) correspondant au substrat (2) et des parties de formation d'ailettes (23) correspondant aux ailettes (3) ; et
un élément de plaque (30) disposé sur un côté en aval dudit corps principal de filière (20),
où ledit élément de plaque (30) est muni d'un passage de matériau (31) pénétrant dans la direction longitudinale et communique avec une ouverture latérale en amont dudit orifice de dégagement (21) dudit corps principal de filière (20),
**caractérisé en ce que**
ledit élément de plaque (30) est muni d'au moins une paroi de séparation verticale (33) (34) de manière à traverser ladite partie de formation de substrat (22) dudit orifice de dégagement (21) dans la direction de l'épaisseur du substrat (2) dans un état dans lequel ledit élément de plaque (30) est combiné avec ledit corps principal de filière (20), grâce à quoi le passage de matériau (31) est divisé en une pluralité de petits passages (31a) (31b) (31c) (31 d) (31 e) (31f).

2. Outil d'extrusion selon la revendication 1, dans lequel deux parois de séparation verticales ou plus (33) (34) sont prévues dans ledit passage de matériau (31) dudit élément de plaque (30).

3. Outil d'extrusion selon la revendication 1 ou 2, dans lequel un espace de convergence (37a) (37b) communiquant avec ladite pluralité de petits passages (31a) (31b) (31c) (31d) (31e) (31f) est prévu à une partie latérale en aval dudit passage de matériau (31) dudit élément de plaque (30).

4. Outil d'extrusion selon l'une quelconque des revendications 1 à 3, dans lequel ladite paroi de séparation verticale (33) (34) est formée de manière à traverser lesdites parties de formation d'ailettes (23).

5. Outil d'extrusion selon l'une quelconque des revendications 1 à 4, comprenant en outre une paroi de séparation verticale (32) formée dans ledit passage de matériau (31) dudit élément de plaque (30), où ladite paroi de séparation horizontale (32) est positionnée à une partie de limite entre ladite partie de formation de substrat (22) et lesdites parties de formation d'ailettes (23) dans un état dans lequel ledit élément de plaque (30) est combiné avec le corps principal de filière (20).

6. Outil d'extrusion selon la revendication 5, dans laquelle ladite paroi de séparation horizontale (32) est formée de manière à avoir une surface inclinée (35) à une partie avant en face de ladite partie de formation de substrat (22), ladite surface inclinée (35) étant inclinée vers lesdites parties de formation d'ailettes (23).

7. Outil d'extrusion selon l'une quelconque des revendications 1 à 6, dans lequel ledit corps principal de filière (20) est muni d'une partie dentée (24) formée à une partie latérale en amont de celle-ci et communiquant avec ledit orifice de dégagement (21) pour introduire le matériau d'extrusion dans ledit orifice de dégagement (21).

8. Procédé de fabrication d'un article profilé avec une pluralité de fines ailettes de type plaque (3) agencées en dents de peigne sur un côté d'un substrat (2), ledit procédé comprenant les étapes consistant à :
préparer un outil d'extrusion (10) selon l'une quelconque des revendications 1 à 7; et
extruder un matériau d'extrusion en utilisant ledit outil d'extrusion (10) de sorte que le matériau d'extrusion divisé par lesdits petits passages (31a) (31b) (31c) (31 d) (31 e) (31f) dudit élément de plaque (30) est fusionné pour être comprimé et collé et ensuite extrudé à travers ledit orifice de dégagement (21).

9. Procédé de fabrication d'un article profilé avec des ailettes selon la revendication 8, dans lequel le matériau d'extrusion est l'aluminium.

10. Procédé de fabrication d'un article profilé avec des ailettes selon la revendication 8 ou 9, dans lequel l'article profilé avec une pluralité de fines ailettes de type plaque est un dissipateur thermique.
